# EUROPEAN PATENT APPLICATION

(11) **EP 4 152 383 A2**
(43) Date of publication of application: **22.03.2023**
(21) Application number: 22190090.5
(22) Date of filing: 12.08.2022
(51) Int. Cl.: H01L 23/544, H01L 23/13, H01L 23/58

(54) **FIDUCIAL FOR AN ELECTRONIC DEVICE**

(30) Priority: 20.09.2021 US 202117479369
(71) Applicant: Intel Corporation, Santa Clara, CA 95054 (US)
(72) Inventor: Kanaoka, Yosuke, Phoenix, 85048 (US); Mcree, Robin, Tempe, 85283 (US); Duan, Gang, Chandler, 85248 (US); Medhi, Gautam, Chandler, 85248 (US); Chen, Huang-Ta, Chandler, 85286 (US)
(74) Representative: Goddar, Heinz J.

(57) **Abstract**

A substrate (110) for an electronic device may include one or more layers. The substrate may include a cavity (140) defined in the substrate. The cavity may be adapted to receive a semiconductor die (150). The substrate may include a fiducial mark (230A) positioned proximate the cavity. The fiducial mark may be exposed on a first surface of the substrate. The fiducial mark may include a first region including a dielectric filler material. The fiducial mark may include a second region including a conductive filler material. In an example, the second region surrounds the first region. In another example, the dielectric filler material has a lower reflectivity in comparison to the conductive filler material to provide a contrast between the first region and the second region.

## Description

### TECHNICAL FIELD

This document pertains generally, but not by way of limitation, to an electronic device including a fiducial mark.

### BACKGROUND

A fiducial mark is utilized as a reference point to determine the positional relationship between a first object and a second object, such as a positional relationship between a first component of an electronic device and a second component of the electronic device.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
- Figure 1: illustrates a schematic, cross-sectional view of one example of an electronic device, in accordance with an example of the present subject matter.
- Figure 2: illustrates a schematic, planar view of one example of the electronic device, in accordance with an example of the present subject matter.
- Figure 3: illustrates a detailed schematic view at the line 3-3 of the electronic device of Figure 2, including one example of a fiducial mark, in accordance with an example of the present subject matter.
- Figure 4: illustrates a schematic view of another example of a fiducial mark, in accordance with an example of the present subject matter.
- Figure 5: illustrates a schematic view of yet another example of a fiducial mark, in accordance with an example of the present subject matter.
- Figure 6: illustrates a schematic view of still yet another example of a fiducial mark, in accordance with an example of the present subject matter.
- Figure 7: illustrates a schematic view of a further example of a fiducial mark, in accordance with an example of the present subject matter.
- Figure 8: illustrates a schematic view of another example of the electronic device, in accordance with an example of the present subject matter.
- Figure 9: illustrates a system level diagram, depicting an example of an electronic device (e.g., system) including one or more of the electronic devices as described in the present disclosure.
- Figure 10: illustrates an example of a method for manufacturing an electronic device, including one or more of the electronic device described herein.

### DETAILED DESCRIPTION

The present inventors have recognized, among other things, that a problem to be solved may include determining the position of a first object (e.g., a substrate) with respect to a second object (e.g., a semiconductor die, for instance an interconnect bridge). Additionally, the present inventors have recognized, among other things, that a problem to be solved may include increasing the accuracy and precision of positioning the second object (e.g., the semiconductor die) with respect to the first object (e.g., a cavity defined in the substrate). Further, the present inventors have recognized, among other things, that a problem to be solved may include distinguishing a fiducial mark from other structures of an electronic device (e.g., a via or an electrical trace).

The present subject matter may help provide a solution to these problems, for example with a substrate for an electronic device. The substrate may include one or more layers. For instance, the one or more layers may include a dielectric material and one or more electrical traces. In another example, a cavity may be defined in the substrate. The cavity may be adapted to receive a semiconductor die.

The electronic device includes one or more fiducial marks. The fiducial marks help determine a positional relationship between components of the electronic device. For instance, the fiducial marks help position a first component of the electronic device relative to a second component of the electronic device. In an example, a semiconductor die may be positioned proximate the cavity of the substrate. For instance, the cavity may receive the semiconductor die, for example to embed the die within the substrate.

The substrate may include a fiducial exposed on a first surface of the substrate. The semiconductor die may include a fiducial mark on a first surface of the die. The fiducial mark may include a first region having a dielectric filler material. The fiducial mark may include a second region having a conductive material. In an example, the second region surrounds the first region. For example, the second region encircles the first region. In yet another example, the dielectric filler material of the first region has a lower reflectivity in comparison to the conductive material of the second region to provide a contrast between the first region and the second region. In another example, contrast between regions of the fiducial mark enhances the detectability of the fiducial mark. For instance, the contrast between the first region and the second region helps distinguish the fiducial mark from other structures of the electronic device.

This overview is intended to provide an overview of subject matter of the present patent application. It is not intended to provide an exclusive or exhaustive explanation of the invention. The detailed description continues and provides further information about the present patent application.

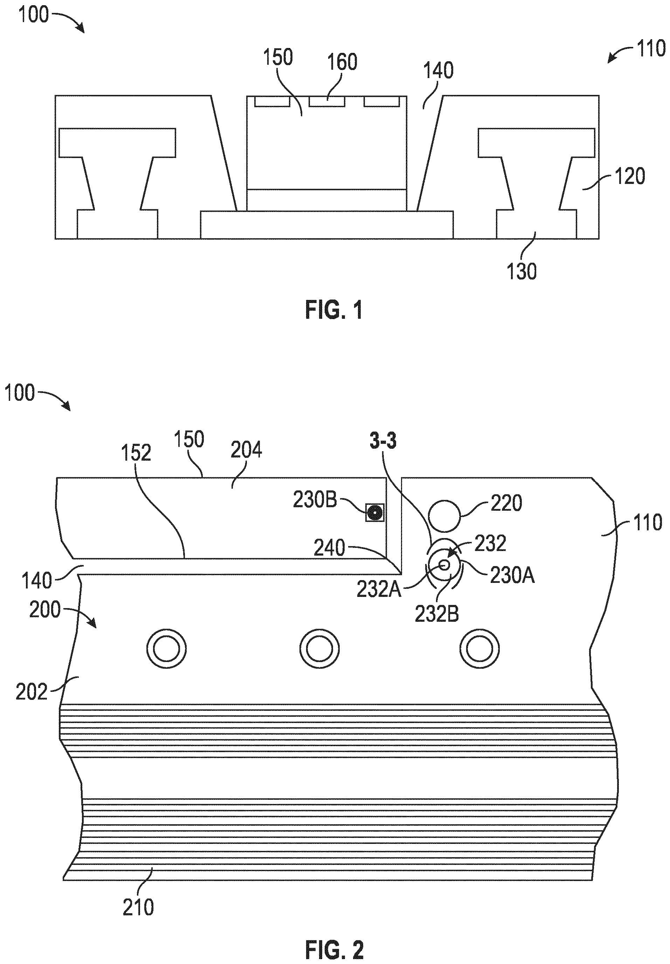

Figure 1 illustrates a schematic, cross-sectional view of one example of an electronic device 100, in accordance with an example of the present subject matter. The electronic device 100 includes a substrate 110. The substrate 110 may include one or more layers, and the one or more layers may include a dielectric material 120 and electrical traces (e.g., the electrical traces 210 of Figure 2). The electronic device 100 may include a via 130, and the via 130 may facilitate the electrical communication between the one or more layers of the substrate 110.

In some examples, the substrate 110 defines a cavity 140 in the substrate 110. For example, a photoresist may be applied to the substrate 110, and the photoresist may be cured. The dielectric material 120 may be coupled to the substrate 110, and the cured photoresist may be removed from the substrate 110 (e.g., by dissolving the cured photoresist). The removal of the photoresist from the substrate 110 may create the cavity 140 in the substrate 110. In another example, the dielectric material 120 is removed (e.g., ablated, for instance with a laser) and the removal of the dielectric material 120 from the substrate 110 creates the cavity 140.

As shown in Figure 1, the cavity 140 may extend partially through the substrate 110. In an example, the cavity 140 extends from a top surface of the substrate 110, and extends into a thickness of the substrate 110. For instance, the cavity 140 extends through the thickness of the substrate 110, and additional layers (e.g., including dielectric material and electrical traces) are coupled to the substrate 110. In another example, a bottom of the cavity 140 is defined by a conductive material. The cavity 140 may have a rectangular periphery, but the present subject matter is not so limited. The periphery of the cavity 140 may have a variety of shapes (e.g., square, circular, triangular, other polygonal shapes, or amorphous in shape).

The electronic device 100 may include a semiconductor die 150, including but not limited to a passive die, an interconnect bridge, a logic die, a memory die, a TSV die, or the like. In an example, the semiconductor die 150 is coupled to a surface of the substrate 110 (e.g., a top surface of the substrate 110). The semiconductor die 150 may be encapsulated in a dielectric material (e.g., the dielectric material 120, or the like).

In another example, the cavity 140 may be adapted to (e.g., sized and shaped) to receive the semiconductor die 150. In an example, the semiconductor die 150 is a first semiconductor die 150, and the first semiconductor die 150 may facilitate the electrical communication of components of the electronic device 100 (e.g., the electrical communication between a second semiconductor die and a third semiconductor die). The semiconductor die 150 may be coupled to a surface (e.g., a bottom surface or wall) of the substrate 110 that defines a portion of the cavity 140. For instance, the semiconductor die 150 may be positioned in the cavity 140 of the substrate 110, and the semiconductor die 150 may be coupled to a bottom surface (e.g., a copper layer) that defines a portion of the cavity 140. The semiconductor die 150 may include a semiconductor material.

As described herein, the semiconductor die 150 may be a first semiconductor die 150 and the die 150 may facilitate the electrical communication between components of the electronic device 100 (e.g., the communication between a second die and a third die). The first semiconductor die 150 may include die contacts 160. The die contacts 160 may include conductive pins, pads, sockets, or the like. The die contacts 160 may facilitate the electrical communication of the semiconductor die 150 with additional structures of the electronic device (e.g., the via 130 or the electrical traces 210 shown in Figure 2).

For instance, additional layers (e.g., of the first dielectric material 120 and electrical traces) may be coupled to the substrate 110, and the additional layers may encapsulate (e.g., enclose, surround, or the like) the semiconductor die 150 in the substrate 110. The electrical traces may be coupled to the die contacts 160, and the electrical traces may route electrical signals to and from the semiconductor die 150. Additionally, the electrical traces may be coupled to a second die and a third die (or additional die), and the electrical signals may be transmitted from the second die, through the first semiconductor die 150, and to the third die (or from the third die to the second die). The first semiconductor die 150 may electrically interconnect two or more die (e.g., the second die and the third die).

Figure 2 illustrates a schematic, planar view of one example of the electronic device 100, in accordance with an example of the present subject matter. As described herein, the substrate 110 may define the cavity 140. In an example, the semiconductor die 150 is coupled to a surface (e.g., a top surface) of the substrate 110. In another example, the semiconductor die 150 may be positioned in the cavity 140 of the substrate 110, and the semiconductor die 150 may be coupled to the substrate 110.

The electronic device 100 may include a surface layer 200. The surface layer 200 may include a dielectric material (e.g., the dielectric material 120 shown in Figure 1, or the like). The surface layer 200 may include conductive material (e.g., copper, gold, aluminum, or the like). The surface layer 200 may be coupled to the substrate 110. The surface layer 200 may include electrical traces 210. For example, conductive material may be plated to a surface (e.g., a top surface) of the substrate 110. The first dielectric material 120 (shown in Figure 1), may electrically isolate individual electrical traces 210.

The surface layer 200 may define a void 220 in the surface layer 200. For instance, a photoresist is applied to the substrate 110, and the photoresist is cured (e.g., by exposure to light) and the photoresist hardens in a desired shape, including but not limited to the shape of void 220. The layer 200 is coupled to the substrate 110 (e.g., by a plating operation, curing operation, or the like) and the layer 200 is coupled with (e.g., surrounds, or envelops) the cured photoresist. The cured photoresist is removed (e.g., with a solvent), and the void 220 will remain in the surface layer. A person having ordinary skill in the art will appreciate other additive operations or subtractive operations may be utilized to define the void 220 in the surface layer 200.

The electronic device 100 may include one or more fiducial marks 230. For example, one or more of the substrate 110 or the semiconductor die 150 may include the fiducial marks 230. Figure 2 shows a first fiducial mark 230A exposed on a surface 202 of the substrate 110. The surface 202 may be included in the layer 200. In another example, Figure 2 shows a second fiducial mark 230B exposed on a surface 204 of the semiconductor die 150. For instance, the second fiducial mark 230B may be adjacent a perimeter edge 152 of the semiconductor die 150. Thus, in an example, the fiducial marks 230A, 230B are simultaneously observable from a side (e.g., top side, or the like) of the electronic device 100 with the semiconductor die 150 received in the cavity 140.

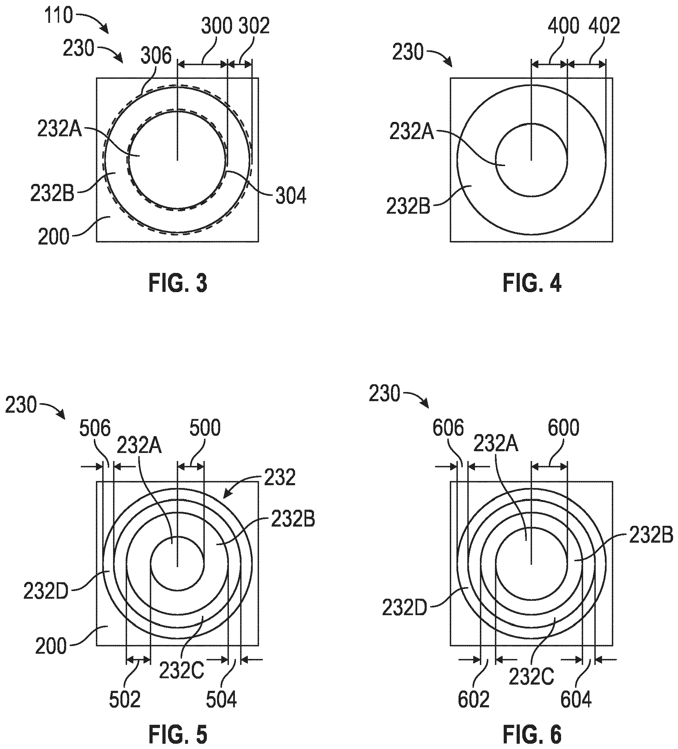

The fiducial mark 230 may include a filler material, including (but not limited to) the first dielectric material 120 (shown in Figure 1), a second dielectric material, or a conductive material. The first dielectric material and the second dielectric material may be different. The void 220 in the surface layer 200 may have various configurations (e.g., corresponding to the design of the fiducial marks shown in Figures 3-7).

The fiducial mark 230 may be positioned in the void 220 that may be defined by the surface layer 200. In an example, the surface layer 200 includes an exposed surface of the substrate 110, and the surface layer 200 defines the void 220 in the exposed surface of the substrate 110. In another example, the fiducial mark 230 may be optionally positioned proximate a corner 240 of the cavity 140 (e.g., in an area near the cavity 140).

As described herein, the fiducial mark 230 may include the filler material, and the filler material may be coupled to the surface layer 200 of the substrate 110. In an example, the filler material includes the first dielectric material 120 or conductive material, and the filler material is positioned in (e.g., deposited into) the void 220 defined in the surface layer 200. For example, excess first dielectric material 120 may be removed from the electronic device 100, and the first dielectric material 120 positioned in the void 220 is cured. The filler material positioned in the void 220 may be coupled to the surface layer 200 and/or the substrate 110 (e.g., by a curing operation, plating operation, or the like). In an example, the fiducial mark 230 includes the first dielectric material 120 or conductive material that is positioned in the void 220.

A person having ordinary skill in the art will appreciate that other operations are possible to create the electronic device 100 including the fiducial mark 230. For instance, the filler material may be cured (e.g., in the configurations shown in Figures 3-6) to form the fiducial mark 230, and the surface layer 200 may be coupled to (e.g., surround, or envelop) the fiducial mark 230. Additionally, the filler material may substantially fill the void 220 (e.g., if the filler material does not flow to the bottom of, and completely fill, the void 220).

The fiducial mark 230 may include one or more regions 232, for example a first region 232A and a second region 232B. In an example, the filler material of the first region 232A includes a dielectric material. The filler material of the second region 232B includes a conductive material. In yet another example, the regions 232 enhance contrast of the fiducial mark 230 with respect to other structures of the electronic device 100. For example, the dielectric material of the first region 232A may have a lower reflectivity in comparison to the conductive material of the second region 232B. In an example, the conductive material of the second region 232B may reflect light with a greater intensity (e.g., have a higher reflectance) than the dielectric material 120 of the first region 232A. In a further example, the first region 232A may absorb (e.g., trap, capture, or refract) light, and the second region 232B is brighter in contrast (to an observer, such as a pick and place apparatus, technician, or the like) to the first region 232A. In yet another example, the fiducial mark 230 includes the first dielectric material 120 (shown in Figure 1) and the first dielectric material 120 absorbs more light in comparison to conductive material (e.g., copper, or the like) of the second region 232B. The dissimilar reflectivity between regions 232 of the fiducial mark 230 (and the surface layer 200) may help improve the contrast between the fiducial mark 230 and the surface layer 200. In still yet another example, the surface roughness of the second region 232B is lower than the surface roughness of other portions of the fiducial mark 230 (or the surface layer 200). For instance, the surface layer 200 may include a conductive material, and the conductive material of the second region 232B of the fiducial mark 230 may be polished, while the surface layer 200 is unaffected by the polishing operation. The dissimilar surface roughness may help improve the contrast between the fiducial mark 230 and the surface layer 200.

Improving the contrast between the fiducial mark 230 and the surface layer 200 may help improve the detectability of the fiducial mark 230 (e.g., when an observer is attempting to locate the fiducial mark 230 included in the electronic device 100). Improving the detectability of the fiducial mark 230 helps reduce labor associated with locating the fiducial mark 230, and may help reduce the costs associated with manufacturing the electronic device 100. In another example, and as discussed in greater detail herein, improving the detectability of the fiducial mark 230 helps improve the accuracy and precision associated with using the fiducial mark 230 as a reference point. For instance, the fiducial mark 230 may be utilized (e.g., referenced by a user or by a machine) as a reference point in a positioning operation to position the semiconductor die 150 in the cavity 140, shown in Figures 1 and 2).

In yet another example, the fiducial mark 230 is utilized to position (e.g., align) and couple the semiconductor die 150 with a surface (e.g., a top surface) of the substrate 110. In still yet another example, the fiducial mark 230 is utilized to position (and couple) electrical components (e.g., resistors, capacitors, inductors, or the like) with respect to the substrate 110. Improving the accuracy and precision associated with using the fiducial mark 230 may improve the performance of the electronic device 100, and may help reduce the waste associated with manufacturing the electronic device 100. For instance, the fiducial 230 helps reduce waste during manufacturing of the electronic device 100, such as by reducing positional misalignment between components of the device 100. Additionally, the fiducial mark 230 may help improve the performance of the electronic device 100 because the increase in accuracy and precision of positioning the semiconductor die 150 with respect to the substrate 110 allows for structures of the semiconductor die 150 (e.g., the die contacts 160 of Figure 1) to have a tighter density (e.g., pitch, or the like) and thereby provide additional electrical communication pathways for the semiconductor die 150 (e.g., enhanced I/O density, or the like).

As described herein, the fiducial mark 230 may be utilized as a reference point. For instance, the fiducial mark 230 may be adapted to locate the semiconductor die 150 with respect to the cavity 140 defined in the substrate 110. The fiducial mark 230 may help determine the geometric properties of the electronic device 100. The fiducial mark 230 may help determine the amount of translation or rotation (or other degrees of freedom) necessary to accurately and precisely position the semiconductor die 150 with respect to the substrate 110, for example to position the semiconductor die 150 in the cavity 140.

The fiducial mark 230 may be electrically isolated form the traces 210 of the substrate 110. For instance, the conductive material included in the fiducial mark 230 may refrain from electrical communication with the electrical traces 210. In yet another example, the fiducial mark 230 refrains from electrical communication with the semiconductor die 150. Accordingly, the fiducial mark 230 is distinguishable with respect to other structures in the electronic device 100 (e.g., a via, pad, or the like). For example, cross-sectioning of the substrate 110 would show the fiducial mark 230 electrically isolated from the traces 250, or the like.

Figure 3 illustrates a detailed schematic view at the line 3-3 of the electronic device of Figure 2, including one example of the fiducial mark 230, in accordance with an example of the present subject matter. Figures 4-7 show additional examples of the fiducial mark 230, in accordance with examples of the present subject matter. Figure 3 shows the surface layer 200 of the substrate 110 and the regions 232 of the fiducial mark 230. The second region 232B may surround (e.g., encircles, encloses, bands, bounds, encompasses, rings, or the like) the first region 232A. The regions 232 of the fiducial mark are exposed on a surface of the substrate 110 (or the semiconductor die 150). For example, the first region 232A and the second region 232B are observable on a surface of the substrate 110 (or on a surface of the semiconductor die 150). Accordingly, the second region 232B surrounds the first region 232A while allowing the first region 232A to be observable on a surface of the substrate 110 (or on a surface of the semiconductor die 150).

The regions of the fiducial mark 230 may have a circular profile (e.g., one or more of cross-section, shape, size, dimensions, contour, radius, perimeter, circumference, outline, boundary, configuration, pattern, arrangement, thickness, or the like). For example, Figure 3 shows the first region 232A of the fiducial mark 230 may have a first circular profile 304. The second region 232B may have a second circular profile 306 (larger than the first circular profile 304). The second region 232B may have an annular shape. The second region 232B may ring about the first region 232A. In another example, a center of the first region 232A may be coincident with a center of the second region 232B. For instance, the second region 232B may be concentrically aligned with the first region 232A. The regions of the fiducial mark 230 may have other profiles, such as a square, polygon, cross, or amorphous in shape.

Figure 3 shows the first region 232A may have a first fiducial dimension 300. The second region 232B may have a second fiducial dimension 302. In an example, the fiducial dimension corresponds to a size of a region of the fiducial mark 230. For instance, the fiducial dimension may correspond to a dimension (e.g., measurement, distance, width, thickness, or the like) between a center of the fiducial mark 230 and a perimeter of a region of the fiducial mark 230. For example, the first fiducial dimension 300 may correspond to a radial dimension between a center of the fiducial mark 230 and a perimeter of the of the first region 232A. In another example, the fiducial dimension corresponds to a dimension between edges of a region of the fiducial mark. For example, 302 may correspond to a radial dimension between edges of the second region 232B (e.g., a distance between an edge of the first region 232A and the surface layer 200).

Figures 4-7 illustrate additional examples of the fiducial mark 230. For example, Figure 4 shows the first region 232A having a third fiducial dimension 400. The first region 232A having the third fiducial dimension 400 is larger than the first region 232A having the first fiducial dimension 300 (shown in Figure 3).

Accordingly, the size of the first region 232A may vary relative to the size of the second region 232B. For instance, the second region 232B has a fourth fiducial dimension 402 in Figure 4. The fourth fiducial dimension 402 is less than the second fiducial dimension 302. The second region 232B may decrease in area in correspondence with an increase in area of the first region 232A.

Figure 5 illustrates yet another example of the fiducial mark 230. The fiducial mark 230 includes the first fiducial region 232A and the second fiducial region 232B. In another example, the fiducial mark 230 may include a third fiducial region 232C. For instance, the third fiducial region 232C may surround the second fiducial region 232B (and accordingly surround the first fiducial region 232A). In an example, the filler material of the first region 232A includes dielectric material. Still further, the fiducial mark 230 may include a fourth fiducial region 232D. For instance, the filler material of the fourth fiducial region 232D includes conductive material. The fourth fiducial region 232D may be adjacent the surface layer 200. In another example, the fourth fiducial region 232D is the outermost region of the one or more regions 232 of the fiducial mark 230.

In another example, Figure 5 shows the first fiducial region 232A may have a fifth fiducial dimension 500. The second fiducial region 232B may have a sixth fiducial dimension 502. The third fiducial region 232C may have a seventh fiducial dimension 504. The fourth fiducial region 232D may have an eighth fiducial dimension 506.

Figure 6 illustrates still yet another example of the fiducial mark 230. As described herein, the regions 232 of the fiducial mark 230 may have varying sizes. Figure 6 shows the first fiducial region 232A may have a ninth fiducial dimension 600. The ninth fiducial dimension 600 may be larger than the fifth fiducial dimension 500 (shown in Figure 5). Accordingly, the size of the first fiducial region 232A may be larger in Figure 5 than in Figure 6. The second fiducial region 232B may have a tenth fiducial dimension 602. The tenth fiducial dimension 602 may be larger than the sixth fiducial dimension 502. Thus, the second fiducial region 232B in Figure 6 may be smaller in size than the size of the second fiducial region 232B in Figure 5. The third fiducial region 232C may have an eleventh fiducial dimension 604. The eleventh fiducial dimension 604 may be larger than the seventh fiducial dimension 504 (shown in Figure 5). Accordingly, the third fiducial region 232C in Figure 6 may be larger in size than the third fiducial region shown in Figure 5. The fourth fiducial region 232D may have a twelfth fiducial dimension 606. The twelfth fiducial dimension 606 may be less than the eighth fiducial dimension 506 (shown in Figure 5). Thus, the fourth fiducial region 232D in Figure 6 may be smaller in size than the fourth fiducial region 232D in Figure 5.

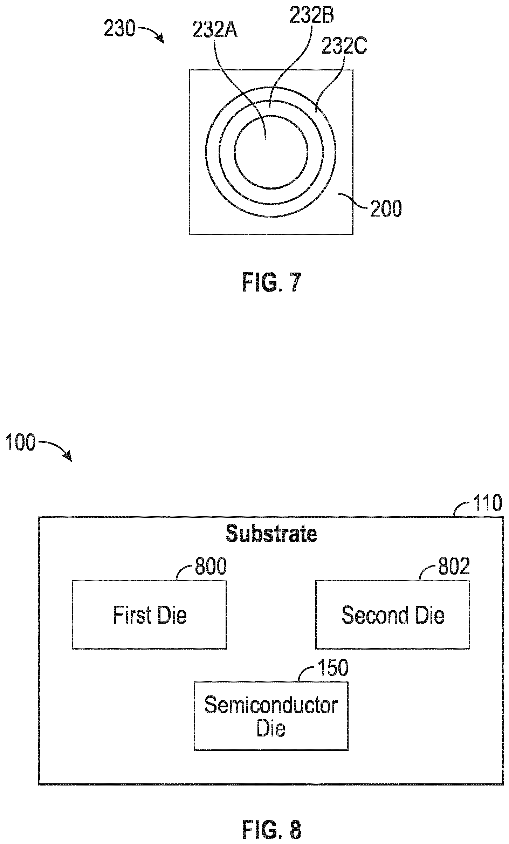

Figure 7 illustrates another example of the substrate 110. As described herein, the substrate 110 may include a surface layer 200. Figure 7 shows the surface layer 200 may include conductive material, such as one or more of copper, gold, or aluminum. For example, the fiducial mark 230 includes the first fiducial region 232A, the second fiducial region 232B, and the third fiducial region 232C. The filler material of the third fiducial region 232C may include dielectric material. The third fiducial region 232C may be adjacent the conductive material of the surface layer 200. The outermost region of the fiducial mark (e.g., the third fiducial region 232C) may include a material dissimilar to the material of the surface layer 200, such as to enhance contrast between the fiducial mark 230 and the surface layer 200.

Figure 8 illustrates a schematic view of another example of the electronic device 100. As described herein, the substrate 110 helps transmit electrical signals between components of the electronic device 100. In an example, the substrate 110 may facilitate electrical communication between a first package die 800 and a second package die 802. For instance, the first package die 800 may transmit an electrical signal to the second package die 802. The semiconductor die 150 may help route electrical signals between the first package die 800 and the second package die 802.

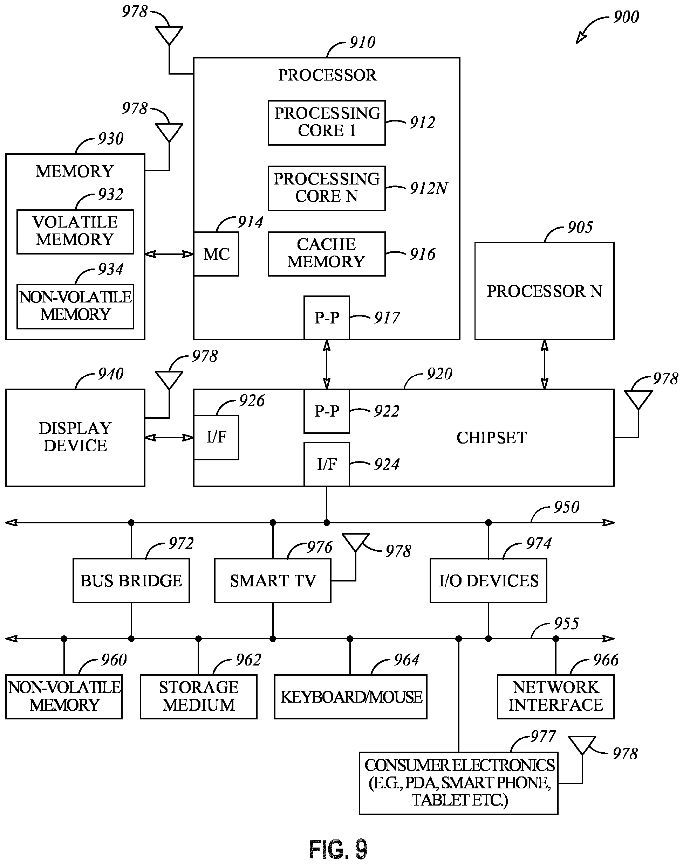

Figure 9 illustrates a system level diagram, depicting an example of an electronic device (e.g., system) including the electronic device 100 as described in the present disclosure. Figure 9 is included to show an example of a higher level device application for the electronic device 100. In one embodiment, system 900 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 900 is a system on a chip (SOC) system.

In one embodiment, processor 910 has one or more processor cores 912 and 912N, where 912N represents the Nth processor core inside processor 910 where N is a positive integer. In one embodiment, system 900 includes multiple processors including 910 and 905, where processor 905 has logic similar or identical to the logic of processor 910. In some embodiments, processing core 912 includes, but is not limited to, pre-fetch logic to fetch instructions, decode logic to decode the instructions, execution logic to execute instructions and the like. In some embodiments, processor 910 has a cache memory 916 to cache instructions and/or data for system 900. Cache memory 916 may be organized into a hierarchal structure including one or more levels of cache memory.

In some embodiments, processor 910 includes a memory controller 914, which is operable to perform functions that enable the processor 910 to access and communicate with memory 930 that includes a volatile memory 932 and/or a non-volatile memory 934. In some embodiments, processor 910 is coupled with memory 930 and chipset 920. Processor 910 may also be coupled to a wireless antenna 978 to communicate with any device configured to transmit and/or receive wireless signals. In one embodiment, an interface for wireless antenna 978 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 932 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 934 includes, but is not limited to, flash memory, phase change memory (PCM), read-only memory (ROM), electrically erasable programmable read-only memory (EEPROM), or any other type of non-volatile memory device.

Memory 930 stores information and instructions to be executed by processor 910. In one embodiment, memory 930 may also store temporary variables or other intermediate information while processor 910 is executing instructions. In the illustrated embodiment, chipset 920 connects with processor 910 via Point-to-Point (PtP or P-P) interfaces 917 and 922. Chipset 920 enables processor 910 to connect to other elements in system 900. In some embodiments of the example system, interfaces 917 and 922 operate in accordance with a PtP communication protocol such as the Intel^{®} QuickPath Interconnect (QPI) or the like. In other embodiments, a different interconnect may be used.

In some embodiments, chipset 920 is operable to communicate with processor 910, 905N, display device 940, and other devices, including a bus bridge 972, a smart TV 976, I/O devices 974, nonvolatile memory 960, a storage medium (such as one or more mass storage devices) 962, a keyboard/mouse 964, a network interface 966, and various forms of consumer electronics 977 (such as a PDA, smart phone, tablet etc.), etc. In one embodiment, chipset 920 couples with these devices through an interface 924. Chipset 920 may also be coupled to a wireless antenna 978 to communicate with any device configured to transmit and/or receive wireless signals.

Chipset 920 connects to display device 940 via interface 926. Display 940 may be, for example, a liquid crystal display (LCD), a plasma display, cathode ray tube (CRT) display, or any other form of visual display device. In some embodiments of the example system, processor 910 and chipset 920 are merged into a single SOC. In addition, chipset 920 connects to one or more buses 950 and 955 that interconnect various system elements, such as I/O devices 974, nonvolatile memory 960, storage medium 962, a keyboard/mouse 964, and network interface 966. Buses 950 and 955 may be interconnected together via a bus bridge 972.

In one embodiment, mass storage device 962 includes, but is not limited to, a solid state drive, a hard disk drive, a universal serial bus flash memory drive, or any other form of computer data storage medium. In one embodiment, network interface 966 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in Figure 9 are depicted as separate blocks within the system 900, the functions performed by some of these blocks may be integrated within a single semiconductor circuit or may be implemented using two or more separate integrated circuits. For example, although cache memory 916 is depicted as a separate block within processor 910, cache memory 916 (or selected aspects of 916) can be incorporated into processor core 912.

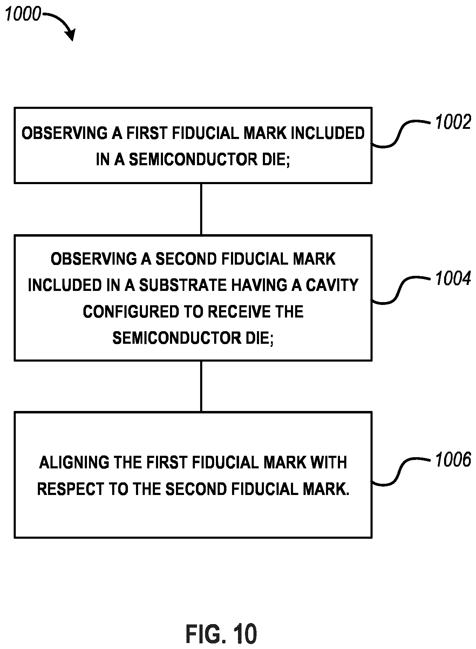

Figure 10 illustrates an example of a method 1000 for manufacturing an electronic device, including one or more of the electronic device 100 described herein. In describing the method 1000, reference is made to one or more components, features, functions and operations previously described herein. Where convenient, reference is made to the components, features, operations and the like with reference numerals. The reference numerals provided are exemplary and are not exclusive. For instance, components, features, functions, operations and the like described in the method 1000 include, but are not limited to, the corresponding numbered elements provided herein and other corresponding elements described herein (both numbered and unnumbered) as well as their equivalents.

The method 1000 includes at 1002 that a first fiducial mark 230A is observed, for example by a pick and place apparatus, a technician, or the like. The first fiducial mark 230A may be included in a semiconductor die 150. At 1004, the method 1000 includes observing a second fiducial mark 230B. The second fiducial mark 230B may be included in a substrate 110. The substrate 110 may include a cavity 140 configured to receive the semiconductor die 150. The method 1000 includes at 1006 aligning the first fiducial mark 230A with respect to the second fiducial mark 230B.

Several options for the method 1000 follow. For instance, aligning the first fiducial mark 230A with respect to the second fiducial mark 230B may include adjusting a position of the semiconductor die 150 relative to the substrate 110. For instance, the position of the semiconductor die 150 may be adjusted based on a comparison of the position of the semiconductor die 150 with respect to the second fiducial mark 230B (in this example included in the substrate 110). In another example, the semiconductor die 150 is located within the cavity 140 in the substrate 110.

### Various Notes & Aspects

Example 1 is a substrate for an electronic device, comprising: one or more layers including a dielectric material and one or more electrical traces; a cavity defined in the substrate, wherein the cavity is adapted to receive a semiconductor die; a fiducial mark positioned proximate the cavity, and the fiducial mark is exposed on a first surface of the substrate, the fiducial mark including: a first region including a dielectric filler material; a second region including a conductive filler material, wherein the second region surrounds the first region; and wherein the dielectric filler material has a lower reflectivity in comparison to the conductive filler material to provide a contrast between the first region and the second region.

In Example 2, the subject matter of Example 1 optionally includes wherein: the first region has a circular profile with a first footprint; the second region has a circular profile with a second footprint; and the second region surrounds the first region such that the first footprint is within the second footprint.

In Example 3, the subject matter of any one or more of Examples 1-2 optionally include wherein the substrate includes a surface layer including a dielectric material, and the second region is adjacent the surface layer.

In Example 4, the subject matter of any one or more of Examples 1-3 optionally include wherein the first region is concentrically aligned with the second region.

In Example 5, the subject matter of any one or more of Examples 1-4 optionally include a third region surrounding both the first region and the second region, the third region including the dielectric filler material.

In Example 6, the subject matter of Example 5 optionally includes wherein each of the first region, the second region, and the third region have a circular profile.

In Example 7, the subject matter of Example 6 optionally includes wherein: the first region has a first radial size; the second region has a second radial size; the third region has a third radial size; and the third radial size is different than the second radial size.

In Example 8, the subject matter of any one or more of Examples 5-7 optionally include a fourth region surrounding each of the first region, the second region, and the third region; and wherein the fourth region includes the conductive filler material.

In Example 9, the subject matter of any one or more of Examples 1-8 optionally include wherein the conductive filler material of the second region of the fiducial mark is electrically isolated from the one or more electrical traces of the substrate.

In Example 10, the subject matter of any one or more of Examples 1-9 optionally include the semiconductor die located in the cavity.

In Example 11, the subject matter of Example 10 optionally includes wherein the semiconductor die includes a die fiducial mark located proximate to an edge of the semiconductor die.

Example 12 is an electronic device, comprising: a semiconductor die, including: a perimeter edge; and a die fiducial mark exposed on a first surface of the die proximate to the perimeter edge of the die, wherein the die fiducial mark includes: a first die fiducial region having a circular profile, the first die fiducial region including a dielectric filler material; a second die fiducial region having a circular profile, the second die fiducial region including a conductive filler material, wherein the second region surrounds the first region; and wherein the dielectric filler material has a lower reflectivity in comparison to the conductive filler material to provide a contrast between the first region and the second region; and a substrate including one or more layers, the substrate having a cavity configured to receive the semiconductor die.

In Example 13, the subject matter of any one or more of Examples 1-12 optionally include wherein: the first die fiducial region has a first footprint; the second die fiducial region has a second footprint; and the second die fiducial region surrounds the first region such that the first footprint is within the second footprint.

In Example 14, the subject matter of any one or more of Examples 12-13 optionally include a third die fiducial region surrounding both the first die fiducial region and the second die fiducial region, the third die fiducial region including the dielectric filler material.

In Example 15, the subject matter of Example 14 optionally includes wherein each of the first die fiducial region, the second die fiducial region, and the third die fiducial region have a circular profile.

In Example 16, the subject matter of Example 15 optionally includes wherein: the first die fiducial region has a first radial size; the second die fiducial region has a second radial size; the third die fiducial region has a third radial size; and the third radial size is different than the second radial size.

In Example 17, the subject matter of any one or more of Examples 14-16 optionally include a fourth die fiducial region surrounding each of the first die fiducial region, the second die fiducial region, and the third die fiducial region; and wherein the fourth die fiducial region includes the conductive filler material.

In Example 18, the subject matter of any one or more of Examples 12-17 optionally include wherein the substrate includes: a substrate fiducial mark positioned proximate the cavity, and the substrate fiducial mark is exposed on a first surface of the substrate, the fiducial mark including: a first substrate fiducial region including a dielectric filler material; a second substrate fiducial region including a conductive filler material, wherein the second substrate fiducial region surrounds the first region; and wherein the dielectric filler material has a lower reflectivity in comparison to the conductive filler material to provide a contrast between the first region and the second region.

In Example 19, the subject matter of Example 18 optionally includes wherein the semiconductor die is located in the cavity.

In Example 20, the subject matter of Example 19 optionally includes wherein the first surface of the substrate is aligned with the first surface of the die.

Example 21 is a method for manufacturing an electronic device, comprising: observing a first fiducial mark included in a semiconductor die; observing a second fiducial mark included in a substrate having a cavity configured to receive the semiconductor die; and aligning the first fiducial mark with respect to the second fiducial mark.

In Example 22, the subject matter of Example 21 optionally includes wherein aligning the first fiducial mark with respect to the second fiducial mark includes adjusting a position of the semiconductor die relative to the substrate.

In Example 23, the subject matter of any one or more of Examples 21-22 optionally include locating the semiconductor die within the cavity in the substrate.

In Example 24, the subject matter of Example 23 optionally includes wherein one or more of the first fiducial mark or the second fiducial mark includes: a first region including a dielectric filler material; a second region including a conductive filler material, wherein the second region surrounds the first region; and wherein the dielectric filler material has a lower reflectivity in comparison to the conductive filler material to provide a contrast between the first region and the second region.

Each of these non-limiting examples can stand on its own, or can be combined in various permutations or combinations with one or more of the other examples.

The above description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Geometric terms, such as "parallel", "perpendicular", "round", or "square", are not intended to require absolute mathematical precision, unless the context indicates otherwise. Instead, such geometric terms allow for variations due to manufacturing or equivalent functions. For example, if an element is described as "round" or "generally round," a component that is not precisely circular (e.g., one that is slightly oblong or is a many-sided polygon) is still encompassed by this description.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A substrate for an electronic device, comprising:
one or more layers including a dielectric material and one or more electrical traces;
a cavity defined in the substrate, wherein the cavity is adapted to receive a semiconductor die; and
a fiducial mark positioned proximate the cavity, and the fiducial mark is exposed on a first surface of the substrate, the fiducial mark including:
a first region including a dielectric filler material;
a second region including a conductive filler material, wherein the second region surrounds the first region; and
wherein the dielectric filler material has a lower reflectivity in comparison to the conductive filler material to provide a contrast between the first region and the second region.

2. The substrate of claim 1, wherein:
the first region has a circular profile with a first footprint;
the second region has a circular profile with a second footprint; and
the second region surrounds the first region such that the first footprint is within the second footprint.

3. The substrate of claim 1, wherein the substrate includes a surface layer including a dielectric material, and the second region is adjacent the surface layer.

4. The substrate of claim 1, wherein the first region is concentrically aligned with the second region.

5. The substrate of claim 1, further comprising a third region surrounding both the first region and the second region, the third region including the dielectric filler material.

6. The substrate of claim 5, wherein each of the first region, the second region, and the third region have a circular profile.

7. The substrate of claim 6, wherein:
the first region has a first radial size;
the second region has a second radial size;
the third region has a third radial size; and
the third radial size is different than the second radial size.

8. The substrate of claim 5, further comprising:
a fourth region surrounding each of the first region, the second region, and the third region; and
wherein the fourth region includes the conductive filler material.

9. The substrate of claim 1, wherein the conductive filler material of the second region of the fiducial mark is electrically isolated from the one or more electrical traces of the substrate.

10. The substrate of claim 1, further comprising the semiconductor die located in the cavity.

11. The substrate of claim 10, wherein the semiconductor die includes a die fiducial mark located proximate to an edge of the semiconductor die.

12. The substrate of claim 10, wherein;
the semiconductor die has a perimeter edge; and
a die fiducial mark is exposed on a first surface of the die proximate to the perimeter edge of the die, wherein the die fiducial mark includes:
a first die fiducial region having a circular profile, the first die fiducial region including a dielectric filler material;
a second die fiducial region having a circular profile, the second die fiducial region including a conductive filler material, wherein the second region surrounds the first region; and
wherein the dielectric filler material has a lower reflectivity in comparison to the conductive filler material to provide a contrast between the first region and the second region.

13. The electronic device of claim 12, wherein:
the first die fiducial region has a first footprint;
the second die fiducial region has a second footprint; and
the second die fiducial region surrounds the first region such that the first footprint is within the second footprint.

14. The electronic device of claim 12, further comprising a third die fiducial region surrounding both the first die fiducial region and the second die fiducial region, the third die fiducial region including the dielectric filler material.

15. The electronic device of claim 19, wherein the first surface of the substrate is aligned with the first surface of the die.
